# EUROPÄISCHE PATENTSCHRIFT

(11) **EP 0 231 970 B1**
(45) Veröffentlichungstag und Bekanntmachung des Hinweises auf die Patenterteilung: **13.07.1994**
(21) Anmeldenummer: 87200113.6
(22) Anmeldetag: 26.01.1987
(51) Int. Cl.: H01L 21/70, H01L 27/01, H05K 3/28

(54) **Dickschicht-Schaltungsanordnung mit einer keramischen Substratplatte**
Thick-film wiring on a ceramic substrate plate
Circuit à couche épaisse sur une plaque de substrat en céramique

(30) Priorität: 31.01.1986 DE 3602960
(43) Veröffentlichungstag der Anmeldung: 12.08.1987
(73) Patentinhaber: Philips Patentverwaltung GmbH, 22335 Hamburg (DE); Philips Electronics N.V., 5621 BA Eindhoven (NL)
(72) Erfinder: Schnitker, Wolfgang, Dr., D-4150 Krefeld (DE); Nover, Michael, Dr., D-4150 Krefeld (DE); Appel, Kay, D-4050 Mönchengladbach 1 (DE)
(74) Vertreter: Erdmann, Anton, Dipl.-Ing.

(56) Entgegenhaltungen:
- EP-A- 0 111 152
- EP-A- 0 167 732
- DE-A- 2 037 261
- DE-A- 2 435 371
- PATENT ABSTRACTS OF JAPAN, Band 9, Nr. 255 (E-349)(1978), 12. Oktober 1985 ; & JP-A-60 102 763
- PATENT ABSTRACTS OF JAPAN, Band 8, Nr. 74 (E-236)(1511), 6. April 1984 ; & JP-A-58 222 546
- IBM TECHNICAL DISCLOSURE BULLETIN, Band 17, Nr. 8, Januar 1975, Seite 2438, New York, USA ; M.R. MATHERS : "Multilayer Hybrid Module".
- J.E.E. JOURNAL OF ELECTRONIC ENGINEERING, Band 20, Nr. 196, April 1983, Seiten 53-56, Tokyo, Japan ; T. INOKUMA : "Several Options Are Available in Producing Thick-Film-Conductors".
- I.E.E. PROCEEDINGS-F, Band 127, Nr. 4, August 1980, Seiten 301-311, Part F, Stevenage ; R.S. PENGELLY et al. : "GaAs monolithic microwave circuits for phased-array applications".

## Beschreibung

Die Erfindung bezieht sich auf eine Dickschicht-Schaltungsanordnung mit einer auf einer Vorderseite einer keramischen Substratplatte aufgebauten elektronischen Schaltung, die aus in Dickschicht-Technik gebildeten Leiterstrukturen und Bauelementen, insbesondere integrierten Schaltkreisen ohne Gehäuse besteht, mit einer gesinterten, nicht-leitfähigen Isolierschicht, die die Zwischenräume zwischen den gesinterten Leiterstrukturen im wesentlichen ausfüllt und auch die Leiterstrukturen überzieht.

Eine derartige Dickschicht-Schaltungsanordnung ist aus der EP-0 111 152 bekannt. Aus diesem Dokument ist es bekannt, mehrere Isolierschichten vorzusehen. Dabei werden beliebige Isolier-Zwischenschichten bezüglich ihrer Oberfläche abtragend bearbeitet und anschließend auf diese bearbeitete Oberfläche wiederum mindestens eine Dickfilm-Leiterschicht und/oder mindestens eine Isolierschicht aufgebracht.

Die FR-OS 20 10 312 beschreibt eine Dickschicht-Schaltungsanordnung, wobei sich eine Glasschicht zwischen den Bauelementen und Leiterstrukturen befindet. Die Glasschicht erstreckt sich auch über diese Strukturen hinweg. Diese Schicht ist zum Schutz der Schaltungsanordnung gegen äußere Einflüsse vorgesehen.

Auch aus der CH-PS 428 877 ist es grundsätzlich bekannt, die Zwischenräume zwischen Leiterbahnen so auszufüllen, daß sich angenähert eine Ebene ergibt. Allerdings ist dieses nicht zum Zwecke des Schutzes der Schaltung vorgesehen, sondern gerade, um den Zugriff eines Schleifkontaktes zu den Leiterbahnen zu erleichtern.

Aus der DE-AS 17 66 144 ist es grundsätzlich bekannt, gegebenenfalls mehrere Isolierschutzschichten vorzusehen.

Dickschicht-Schaltungsplatten, die aus gesinterten Schichten auf einer keramischen Substratplatte gebildet werden, werden als sogenannte Multilayer-Anordnungen eingesetzt, um sich kreuzende Leiterbahnen im Überlappungsbereich gegeneinander zu isolieren. Diese Leiterbahnen oder Widerstände abdeckenden, isolierenden Dickschichtpasten haben gesintert eine Temperaturfestigkeit, die oberhalb der Zersetzungstemperatur organischer Substanzen liegt, und widerstehen allen bekannten organischen Lösungsmitteln. Es ist auch bekannt, Dickschicht-Schaltungen ganz oder teilweise mit einem Überzug aus einem Epoxydharz oder anderen organischen Schichten (z. B. auf Siliconbasis, Polyurethane) zu überziehen. Diese Überzüge verdecken die unter ihnen befindlichen Strukturen aber nur sehr unvollkommen. Ein Fachmann kann diese Überzüge durch Erwärmen oder Lösungsmittel bzw. durch eine Kombination dieser beiden Aufweichverfahren ohne Schwierigkeiten entfernen, wonach die gesamte Struktur der Dickschicht-Schaltung mit Leiterbahnen und Bauelementen frei liegt.

Die bekannten Dickschicht-Schaltungsanordnungen sind so aufgebaut, daß ein Dritter, der entweder die Schaltungsanordnung kopieren oder beispielsweise an elektronische Signale oder Speicherdaten der Schaltungsanordnung oder nachgeordneter Schalteinheiten herankommen will, mit einfachen Mitteln, wie beispielsweise über Prüfspitzen mittels Kratzen oder Bohren, alles für ihn Interessante abtasten kann. Im Rahmen zunehmender elektronischer Datenspeicherung z. B. bei Geldinstituten oder Behörden tritt das Problem auf, daß an den Daten, beispielsweise Geldkonten, Personalangaben oder dergl., interessierte Personen versuchen, unbefugt an solche Daten heranzukommen. Es kommt also zunehmend darauf an, daß der Zugriff zu Schaltungsanordnungen, welche schützenswerte Daten elektrisch verarbeiten bzw. umsetzen oder verschlüsseln, so weit wie möglich erschwert wird. Je höher die Zugriffssicherheit solcher Schaltungsanordnungen und ihres internen Datenleitungssystems wird, desto aufwendiger werden die von sogenannten Knackern aufzuwendenden, geistig logischen und maschinellen Aufwendungen, um über optische Analysen (z. B. Betrachtung im Durchlicht), Durchstrahlung z. B. mit Röntgenstrahlen oder das Auslesen elektrischer Signale an die gewünschten Informationen über die Funktionsweise der Schaltungsanordnung heranzukommen und evtl. Operationen vorzunehmen.

Es ist Aufgabe der Erfindung, die Zugriffssicherheit einer Dickschicht-Schaltungsanordnung derart zu erhöhen, daß die Aufwendungen, die zum Knacken der Schaltungsanordnung, d. h. zur Feststellung der vollständigen Funktionsweise der Schaltungsanordnung durch Ermittlung des Leiterbahnverlaufes zwischen den einzelnen Komponenten sowie das Auslesen elektrischer Signale, notwendig sind, stark erhöht werden entsprechend dem gewünschten Sicherheitsbedürfnis und daß bei stark erhöhtem Sicherheitsbedürfnis der technische und zeitliche Aufwand zum Knacken der Schaltungsanordnung das auch Profis zur Verfügung stehende Maß soweit wie möglich übersteigt.

Die gestellte Aufgabe ist erfindungsfindungsgemäß dadurch gelöst, daß zur Abdeckung der Dickschicht-Schaltungsanordnung oder wesentlicher Teile gegen unbefugten Zugriff folgender Schichtaufbau der gesinterten, nicht-leitfähigen Isolierschicht vorgenommen ist:
1. eine Füllschicht in den Zwischenräumen füllt diese zwischen den elektrisch wirksamen Dickschicht-Leiterstrukturen derart auf, daß die Oberseiten der elektrisch wirksamen Strukturen und der die Zwischenräume zwischen ihnen füllenden, isolierenden, aus Isolierpaste gebildeten Füllschicht angenähert in einer Ebene liegen,so daß eine kombinierte Leiter-/Füllschicht gebildet ist,
2. es ist wenigstens eine isolierende erste Dickschicht-Zugriffsschutzschicht deckend und einebnend über der kombinierten Leiter-/Füllschicht angeordnet, die durch zusätzliche Sichtbehinderungseinlagen (Farbe, Partikel) ein optisches Erkennen der darunterliegenden Strukturen erschwert.

Eine derartige Dickschicht-Anordnung ist gegen unbefugten Zugriff sehr weitgehend gesichert, da die erste Dickschicht-Zugriffsschutzschicht ein optisches Erkennen der darunterliegenden Strukturen durch zusätzliche Sichtbehinderungseinlagen erschwert. Für einen unbefugten Zugriff wäre es von Bedeutung, daß zunächst einmal das Schaltungsmuster und damit die Verbindungen zwischen den konkreten Bauelementen feststellbar sind. Eine im wesentlichen ebene Oberfläche der Dickschicht-Substratplatte erschwert dieses Erkennen in starkem Maße. Durch ein Einfärben der zu sinternden Paste und/oder Isolierpartikeleinschlüsse ist eine Durchsichtmöglichkeit auf die Schaltungsanordnung unterbunden.

Nach einer weiteren Ausgestaltung der Erfindung ist vorgesehen, daß die erste Dickschicht-Zugriffsschutzschicht mit wenigstens einer zweiten Dickschicht-Zugriffsschutzschicht abgedeckt ist, die wenigstens teilweise flächig leitend ausgebildet ist und/oder wenigstens teilweise weitere Leiterstrukturen aufweist, die elektrisch funktionsfähig oder funktionsunfähig sind.

Es ist an sich aus dem Buch von D.W. Hamer und J.V. Biggers "Thick Film Hybrid Microcircuit Technology", 1983, Seite 70, bekannt, über der Isolierschicht eine zweite Leiterstruktur anzubringen; diese ist aber, da es sich um Leiterbrücken handelt, ein Bestand der darunterliegenden ersten Leiterstruktur.

Nach einer weiteren Ausgestaltung der Erfindung ist vorgesehen, daß der Schichtaufbau und die Abdeckung der zweiten Dickschicht-Zugriffsschicht, soweit weitere Leiterstrukturen vorhanden sind, wie bei der kombinierten Leiter-/Füllschicht und der ersten Dickschicht-Zugriffsschutzschicht erfolgt.

Nach einer weiteren Ausgestaltung der Erfindung ist vorgesehen, daß sich der Schichtaufbau wenigstens einmal übereinander wiederholt. Auf diese Weise läßt sich im Rahmen der verbesserten Zugriffssicherheit eine mehrlagige Leiterstruktur erzielen.

Nach einer weiteren Ausgestaltung der Erfindung ist vorgesehen, daß die zweite Dickschicht-Zugriffsschutzschicht in Form von weiteren Leiterstrukturen aufgebaut ist, die wenigstens teilweise an funktionsspezifischen Stellen in die elektronische Schaltung der Schaltungsanordnung eingreifen. Vorzugsweise kann dies in der Weise erfolgen, daß die zweite Dickschicht-Zugriffsschutzschicht in die elektronische Schaltung der Schaltungsanordnung derart eingreift, daß bei Unterbrechungen oder Kurzschlüssen der Strukturen der zweiten Zugriffsschutzschicht Funktionsfehler, wie Speicherverluste oder Speicherlöschungen, in integrierten Schaltkreisen der Schaltungsanordnung hervorgerufen werden. In diesem Zusammenhang ist es auch möglich, daß die originären Leiterstrukturen der Schaltungsanordnung und die darüberliegenden Zugriffsschutzschicht-Strukturen derart ausgebildet sind, daß bei der Untersuchung mit materiedurchdringenden Strahlen der Funktionszusammenhang dieser Strukturen nicht erkennbar ist. Die Analyse von Schaltungsanordnungen mit erhöhter Zugriffssicherheit gegen Röntgen- oder andere ionisierende Strahlen ist dadurch stark erschwert. Zur weiteren Verbesserung der Zugriffssicherheit können eine oder nehrere der zweiten Dickschicht-Zugriffsschutzschichten kombiniert sein.

Nach einer weiteren Ausgestaltung der Erfindung ist vorgesehen, daß auf der Rückseite der keramischen Substratplatte ein weiterer Schaltungsaufbau mit Abdeckung wie auf der Vorderseite vorgesehen ist. Ebenso ist es auch möglich, daß auf der Rückseite wenigstens eine zweite Dickschicht-Zugriffsschutzschicht in Kombination mit wenigstens einer Füll- und einer ersten Zugriffsschutzschicht auf der Substratplatte angeordnet ist. Auf diese Weise ist vermieden, daß ein Knacker von der Rückseite der keramischen Substratplatte her an das tatsächliche Schaltungsmuster herangeht.

Nach einer weiteren Ausgestaltung der Erfindung ist vorgesehen, daß die die Zwischenräume der elektrisch wirksamen Dickschicht-Strukturen auffüllende Dickschicht-Füllschicht eine gesinterte Dickschicht-Glasschicht ist. Ebenso ist nach einer weiteren Ausgestaltung der Erfindung vorgesehen, daß die abdeckende und einebnende erste Dickschicht-Zugriffsschutzschicht aus einer gesinterten Dickschicht-Glasschicht besteht. Es kann auf diese Weise bei der Erzielung der Zugriffssicherheit auf die bekannte Schichtbildung im Rahmen der Dickschicht-Technologie zurückgegriffen werden.

Die zweite Zugriffsschutzschicht kann auf verschiedene Art gestaltet werden, je nachdem, wie hoch die Anforderungen an die Zugriffssicherheit sind. Sind beispielsweise nur Teile der Schaltungsanordnung gefährdet, dann ist vorgesehen, daß die zweite Dickschicht-Zugriffsschutzschicht ganz oder in einer bzw. mehreren Teilflächen aus einer gesinterten Dickschicht-Leiter- und/oder Widerstandspaste gebildet ist. Steigen die Sicherheitsanforderungen, dann ist vorgesehen, daß die Strukturen der zweiten Zugriffsschutzschicht als Mäander, als Kamm, als Spirale oder als Schaltbilder ausgebildet sind. Eine weitere Steigerung der Zugriffssicherheit wird erzielt, wenn die Leiter der Schaltbilder aus der zweiten Zugriffsschutzschicht zur Täuschung für die Funktion notwendige und/oder überflüssige und/oder eine andere Funktion vortäuschende Verbindungen herstellen.

Die Erfindung wird anhand der Zeichnungen näher erläutert. Es zeigen:
Fig. 1 eine gegen unbefugten Zugriff gesicherte keramische Substratplatte mit einer Leiterbahnschicht, einer Füllschicht, einer Ausgleichsschicht auf der Vorderseite der Platte,
Fig. 2 eine keramische Substratplatte nach Fig. 1 mit einem die Schaltungsanordnung gegen Zugriff sichernden gleichartigen Schaltungsaufbau auf der Vorder- und Rückseite,
Fig. 3 eine keramische Substratplatte nach Fig. 1 mit einem mehrfachen Leiterbahnsystem und jeweils mehrfachen Ausgleichsschichten,
Fig. 4 eine keramische Substratplatte nach Fig. 3 mit gleichartigem Aufbau auf der Vorder- und Rückseite,
Fig. 5 ein Ausführungsbeispiel einer im wesentlichen flächig ausgebildeten zweiten Zugriffsschutzschicht,
Fig. 6 eine zweite Zugriffsschutzschicht mit einer elektrischen Struktur,
Fig. 7 ein Ausführungsbeispiel einer im wesentlichen strukturiert ausgebildeten Zugriffsschutzschicht mit mehreren Varianten elektrischer Leiterstrukturen.

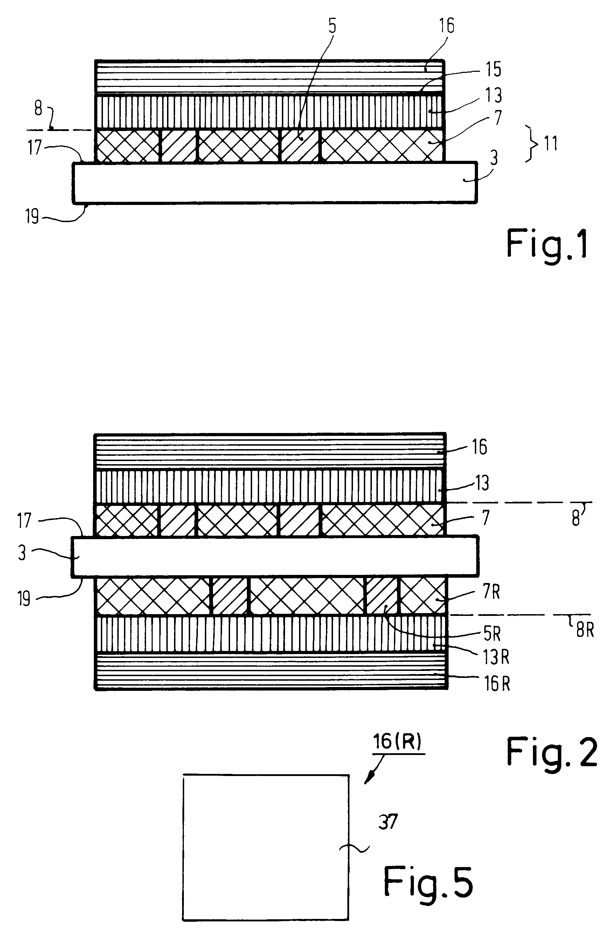

Um eine Dickschicht-Schaltungsanordnung auf einer Dickschicht-Substratplatte 3 gegen unbefugten Zugriff, beispielsweise von Knackern, zu sichern, sind die Schichten auf einer in Fig. 1 dargestellten Substratplatte 3 auf eine besondere Art und Weise ausgebildet. Unmittelbar auf der Substratplatte befinden sich zunächst einmal Leiterbahnen 5, die durch Sintern einer leitfähigen Paste gebildet sind. Die Zwischenräume zwischen den Leiterbahnen sind ausgefüllt mit einer Dickschicht-Füllschicht 7, die durch Sintern einer in die Zwischenräume eingebrachten, nicht-leitfähigen Dickschicht-Paste, die Ausgangsbasis der Füllschicht 7 ist, gebildet ist. Die Dickschicht-Paste kann beispielsweise eine Dickschicht-Glaspaste sein. Die Oberseiten der Leiterbahnen 5 und der die Zwischenräume zwischen ihnen füllenden Füllschicht 7 liegen in einer sich im wesentlichen über die abzudeckenden Teile der Substratplatte 3 erstreckenden Ebene 8. Diese kombinierte Leiter-/Füllschicht 11 ist mittels einer isolierenden ersten Dickschicht-Zugriffsschutzschicht 13 abgedeckt, die im folgenden als Ausgleichsschicht 13 bezeichnet ist. Diese Ausgleichsschicht 13 erstreckt sich deckend über die kombinierte Leiter-/Füllschicht 11 hinweg. Die Oberseite 15 der Ausgleichsschicht 13 ist eingeebnet. Die Ausbildung dieser eingeebneten Ausgleichsschicht 13 kann beispielsweise dadurch erfolgen, daß auf die gesinterte Leiter-/Füllschicht zunächst im wesentlichen über die ganze Fläche der Substratplatte hinweg flächendeckend eine isolierende Dickschicht-Paste aufgetragen wird, wobei darauf geachtet wird, daß die Paste gleichmäßig ausläuft zur Bildung einer ebenen Oberseite 15. Auf diese Oberseite ist eine später näher zu erläuternde zweite Dickschicht-Zugriffsschutzschicht 16 aufgebracht, die im folgenden als Funktionsschicht 16 bezeichnet ist.Diese Funktionsschicht 16 kann die darunterliegende Schaltungsanordnung je nach dem Anforderungsgrad an die Zugriffssicherheit zusätzlich verschleiern.

Während die auf der Vorderseite 17 der keramischen Schaltungsplatte 3 aufgebrachte Abdeckung die Schaltungsanordnung auf der Vorderseite 17 schützt, ist die Schaltungsanordnung von der Rückseite 19 her durch die keramische Substratplatte geschützt. Die keramische Substratplatte 3 besteht aus einem durchgehend einheitlichen Material, durch das hindurch grundsätzlich mit geschickten geeigneten Methoden, z. B. Bohren, Informationen über die Funktionsweise der Schaltungsanordnung auf der Vorderseite 17 auslesbar wären. Um die Zugriffssicherheit der Schaltungsanordnung über den durch die Materialeigenschaft der keramischen Substratplatte bereits gegebenen Schutz hinaus weiter zu erhöhen, sind bei der Ausführungsform nach Fig. 2 sowohl die Vorderseite 17 als auch die Rückseite 19 der keramischen Schaltungsplatte 3 mit einer zugriffssicheren Abdeckung versehen. Der Aufbau dieser Abdeckung soll dabei auf der Rückseite vorzugsweise dem Aufbau der Vorderseite entsprechen.

Dementsprechend sind also auf der Rückseite 19 der keramischen Schaltungsplatte Leiterbahnen 5R vorgesehen. Die Lücken zwischen diesen Leiterbahnen 5R sind mit Hilfe der Füllschicht 7R abgedeckt. Auf die sich dabei ergebende Ebene 8R ist eine isolierende Ausgleichsschicht 13R aufgebracht. Über dieser Ausgleichsschicht 13R befindet sich dann wieder eine Funktionsschicht 16R.

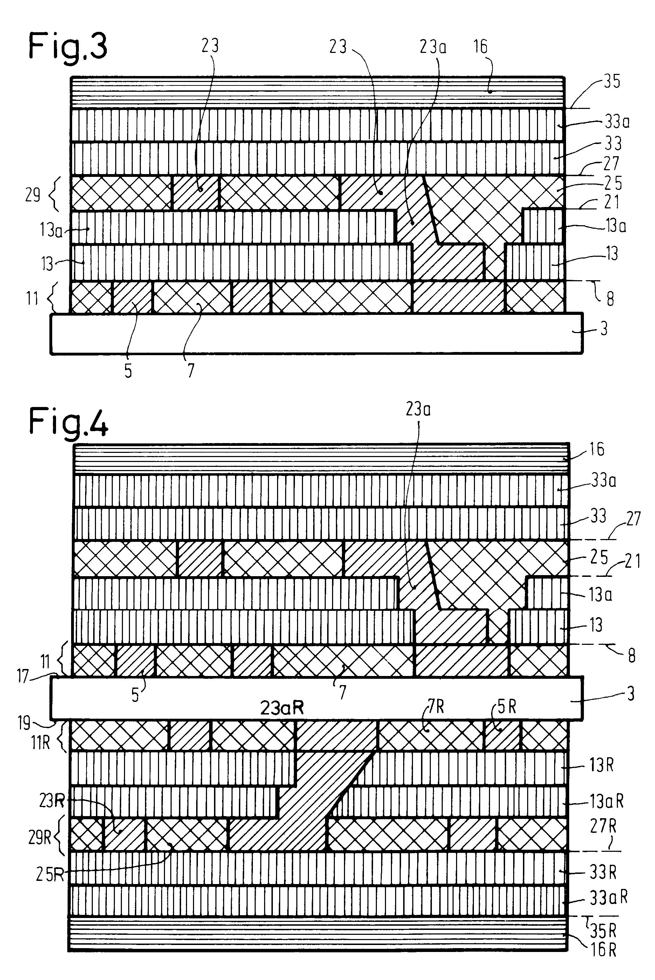

Bei Dickschicht-Schaltungsanordnungen ist es wegen der gedrängten Leitungsführung im allgemeinen unumgänglich, daß es mehrere Leiterbahnebenen gibt. Unterschiedliche Leiterbahnebenen sind so ausgebildet, daß der darüberliegende Leiter im Kreuzungsbereich von dem darunterliegenden Leiter durch typischerweise zwei zwischengefügte, übereinandergelegte Isolierschichten getrennt ist. Diese Isolierschichten bestehen beispielsweise aus gesinterten Dickschicht-Glaspasten. In Fig. 3 ist nun dargestellt, wie bei der vorliegenden Dickschicht-Schaltungsanordnung bereits eine flächige, sich über die abzudeckenden Teile der Substratplatte 3 erstreckende Abdeckung mittels zweier Ausgleichsschichten 13 und 13a vorgenommen ist. Dies ist von Vorteil, weil sich beim Aussintern erneut Unebenheiten bilden können, die sich mit zwei Ausgleichsschichten 13 und 13a besser einebenen lassen. Die beiden Ausgleichsschichten 13 und 13a werden auf die gleiche Weise gebildet. Auf die nun gut eingeebnete Oberseite 21 der flächigen Ausgleichsschicht 13a kann eine weitere Leiterbahnebene aufgebracht sein. Die Leiter 23 dieser Ebene können über eine Brücke 23a an den gewünschten Stellen mit darunterliegenden Leitern 5 kontaktiert sein. Auch die Zwischenräume zwischen den Leitern 23 sind wieder mit einer Füllmasse 25 ausgefüllt, so daß die Oberseite 27 der kombinierten Schicht 29 aus Leitern 23 und Füllmasse 25 im wesentlichen eben ist über die abzudeckenden Teile der keramischen Substratplatte 3 hinweg.

Die kombinierte Leiter-/Füllschicht 29 ist nun wieder abgedeckt mit Hilfe von mindestens einer, vorzugsweise aber zwei eingeebneten Ausgleichsschichten 33 und 33a, die auf die gleiche Weise gebildet und an der Oberfläche eingeebnet sind wie die Ausgleichsschichten 13 und 13a. Auf diese Weise ist nun eine Beschichtung entstanden, die in ihrem Leitungsmuster von außen her nicht mehr erkennbar ist oder durch einfaches Kratzen oder Anbohren ermittelt werden kann.

Um die Zugriffssicherheit weiter zu erhöhen, ist auf die Oberseite 35 der Ausgleichsschicht 33a eine Funktionsschicht 16 aufgebracht. Diese Funktionsschicht 16 kann wieder auf verschiedene Art und Weise gebildet sein.

Fig. 4 zeigt, entsprechend Fig. 2, einen Aufbau, bei dem auf der Vorderseite 17 eine Schichtung nach Fig. 3 vorgesehen ist, die auf der Rückseite 19 durch eine entsprechende Schichtung nach Fig. 3 ergänzt ist. Auf der Rückseite 19 gibt es dementsprechend, ebenso wie auf der Vorderseite 17, eine Schicht 11R mit Leitern 5R, zwischen denen Füllmasse 7R angeordnet ist. Die Schicht 11R ist abgedeckt von Ausgleichsschichten 13R und 13aR. Oberhalb der Schicht 13aR gibt es eine weitere kombinierte Leiter-/Füllschicht 29R mit Leitern 23R und die Zwischenräume ausfüllender Füllmasse 25R. Die Oberseite 27R ist wieder abgedeckt mit Ausgleichsschichten 33R und 33aR. Die Oberseite 35R der Ausgleichsschicht 33aR ist dann wieder bedeckt mit einer Funktionsschicht 16R. Wie auf der Vorderseite, auf der eine Brücke 23a dargestellt ist, ist auf der Rückseite auch eine Brücke 23aR vorgesehen.

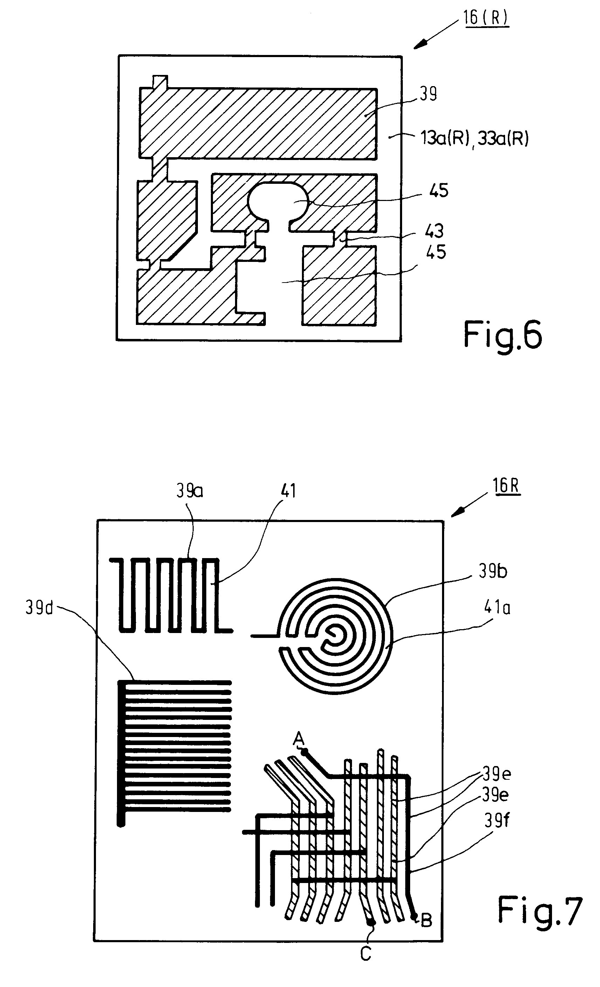

Eine einfache Ausbildungsart einer Funktionsschicht 16 bzw. 16R ist in Fig. 5 dargestellt. In diesem Fall besteht die Funktionsschicht 16(R) aus einer elektrisch leitfähigen Schicht 37, die großflächig aufgebracht ist und beispielsweise aus einem gesinterten Dickschicht-Widerstandsmaterial besteht.

Fig. 6 zeigt eine Funktionsschicht 16(R), die eine einfache Leiterstruktur 39 aufweist. Schutzbedürftige Bereiche sind dabei oberhalb der obersten Ausgleichsschicht 13(R), 33a(R) mit gesinterten Widerstandsflächen 39 abgedeckt. Die einzelnen Widerstandsflächen sind untereinander über Leiterbahnen 43 miteinander verbunden. Besondere Aussparungen 45 befinden sich beispielsweise an Orten integrierter Schaltkreise. Diese werden erst nach dem Sintern des Substrates aufgebracht und beispielsweise mit Epoxydharz abgedeckt.

Fig. 7 zeigt eine andere Ausführungsform der Funktionsschicht 16 bzw. 16R. Diese Funktionsschicht 16(R) besteht nach dem Bild, oben links, entweder in Teilen oder in ihrer Gesamtheit aus einer mäanderförmig ausgebildeten leitfähigen Schicht 39a, die entweder einen gewissen Innenwiderstand aufweist (Widerstandspasten) oder voll-Leitfähig (Leiterbahnpasten) ist. Die Zwischenräume zwischen diesen Strukturen können wieder, wie bei den vorhergehenden Figuren, mit Füllmasse 41 ausgefüllt sein, entsprechend den Schichten 11(R) und 29(R). Die Leiterbahn kann gemäß Fig. 7, oben rechts, auch schneckenartig ausgebildet sein, wie es durch 39b angedeutet ist. Zwischenräume 41a sind wieder mit Füllmasse entsprechend den Schichten 11(R) und 29(R) ausgefüllt. In Fig. 7, links unten, ist die Leiterstruktur 39d kammförmig gestaltet.

Bei der Darstellung in Fig. 7, unterer rechter Bildteil, ist eine Ausführungsform der Funktionsschicht 16 dargestellt, die zum Ziel hat, die Gewinnung von Informationen über die Schaltungsanordnung mit materiedurchdringenden Strahlen (z. B. Röntgenstrahlung) zu verhindern.

Mindestens die schraffiert gezeichneten Strukturen 39e sind in diesem Fall so aufzubringen, daß sie visuell nicht erkennbar sind. Wegen des geringen Abstandes zu den geschwärzten Strukturen 39f in einer darüberliegenden Schicht von Leiterstrukturen sind diese mit den bekannten Anordnungen zur Analyse mit durchdringenden Strahlen in der Richtung senkrecht zur Substratplatte räumlich von den oberen Strukturen nicht zu trennen. Es ist daher mit derartigen Techniken nicht zu erkennen, ob und, wenn ja, welche Teilstrukturen elektrisch leitend miteinander verbunden sind. Auch diese Strukturen können groß- oder teilflächig eingesetzt werden.

Eine andere Ausführungsform zu diesem Zweck kann darin bestehen, an den Ort der Zwischenräume zwischen den Teilen der unteren Struktur in einer oberen, visuell nicht erkennbaren Struktur gleichartiges Material aufzubringen. In diesem Fall erhält man mit durchdringender Strahlung einen flächigen, gleichartigen Bereich, der keine inneren Strukturen zeigt.

Die Darstellung in Fig. 7, unterer rechter Bildteil, ist also als eine Art von Verwirrschaltung aufgebaut. Die Ausführung kann so gewählt werden, daß Teile der Funktionsschicht in den Leitungsverlauf integriert sind. In einer weiteren Ausführungsvariation ist es denkbar, die Leiterzüge der Verwirrschaltung so zu legen, daß sie im Strahlengang der materiedurchdringenden Strahlen in der Originalschaltung Schaltungszüge vortäuschen, die in Wirklichkeit gar nicht existieren.

Die geometrische Ausbildung der Funktionsschicht kann auch so gewählt werden, daß durch ihr Vorhandensein der originäre Leitungsverlauf verdeckt wird bzw. in der Durchstrahlung nicht zu erkennen ist, wie der originäre Verlauf weiterführt. In der Durchstrahlung ist also nicht zu unterscheiden, ob die Leitungsverbindung zwischen einem Punkt A und B oder zwischen A und C besteht, da im Durchstrahlungsbild eine Überlagerung und Gabelung der originären und der imaginären Leiterzüge vorliegt und bei einer Durchstrahlung eine Unterscheidung zwischen oben und unten aufgrund des geringen Höhenunterschieds von einigen Mikrometern nicht möglich ist.

Zusammenfassend kann also zu Fig. 7, unten rechts, ausgeführt werden, daß die Funktionsschicht-Strukturen in bezug auf die darunterliegenden originären Leiterbahn-Strukturen derart ausgebildet sind, daß bei einer Parallelprojektion der Funktionsschicht-Struktur auf die originären Leiterbahn-Strukturen sich als Summe beider Strukturen Verknüpfungen zwischen den einzelnen Komponenten der Schaltungsanordnung ergeben, die für einen die Funktionsweise der Schaltung nicht kennenden Dritten nicht ohne weiteres feststellen lassen, welche elektrischen Verknüpfungen durch die entsprechend strukturierte Funktionsschicht nur vorgetäuscht werden. Dieses in bezug auf das originäre Leiterbahnmuster der Schaltungsanordnung entsprechend ausgestaltete und positionierte Funktionsschichtmuster erschwert bei Untersuchungen mit materiedurchdringenden Strahlen die Analyse der tatsächlichen Leitungsführungen der Schaltungsanordnung in hohem Maße. Dies ist besonders wichtig, da ein absoluter Schutz gegen Durchstrahl-Untersuchungen nach dem derzeitigen Wissensstand nicht möglich ist. Auch Blei-Bedeckungen sind unsicher, notwendigerweise sehr dünn und damit nicht vollständig absorbierend und mit den gesinterten Pasten nicht unlösbar verbindbar. Es kommt also darauf an, im Durchstrahlungsbild so viel Verwirrung vorzufinden, daß der Entschlüssel-Aufwand so viel Arbeit und Zeit erfordert, daß der Eingriffswille bzw. das Entschlüsselungsbestreben erlahmen und zur Aufgabe bewegen.

Dies gilt auch für den Fall mechanischer und elektrischer Prüfversuche, wenn die Leiterstrukturen 39 bis 39f an funktionsspezifischen Stellen in die elektronische Schaltung der Schaltungsanordnung eingreifen. Werden die elektrisch leitfähigen Strukturen 39 bis 39f durch solche Versuche beispielsweise unterbrochen oder kurzgeschlossen, dann ist die Schaltungsanordnung beispielsweise so eingerichtet, daß sie entweder völlig außer Funktion fällt (z. B. durch Speicherverlust) oder sogar durch diese Manipulation in eine Fehlfunktion (Falschprogrammierung) gebracht wird. Wird dabei beispielsweise die Schaltungsfunktion verändert, etwa dadurch, daß durch Auslösen einer Reset-Funktion Speicherinhalte gelöscht oder Prozessoren in einen die ursprüngliche Funktion nicht mehr erkennen lassenden Zustand gebracht werden oder auch durch dann auftretende Überspannugen und -ströme, können zentrale Bauelemente in ihrer Funktion gestört oder zerstört werden. Mehrere Arten von Leiterbahnen der Funktionsschicht 16(R) können miteinander kombiniert sein. Von Vorteil ist es in diesem Zusammenhang, wenn die Spannungsversorgung für die integrierten Schaltkreise durch die Funktionsschicht oder Funktionsschichten verläuft. Ein Eingriff an einer solchen Zuleitung kann zu den beschriebenen, nicht mehr reparablen Defekten führen.

## Patentansprüche

1. Dickschicht-Schaltungsanordnung mit einer auf einer Vorderseite (17) einer keramischen Substratplatte (3) aufgebauten elektronischen Schaltung, die aus in Dickschicht-Technik gebildeten Leiterstrukturen (5) und Bauelementen, insbesondere integrierten Schaltkreisen ohne Gehäuse besteht, mit einer gesinterten, nicht-leitfähigen Isolierschicht, die die Zwischenräume zwischen den gesinterten Leiterstrukturen (5) im wesentlichen ausfüllt und auch die Leiterstrukturen (5) überzieht, dadurch gekennzeichnet, daß zur Abdeckung der Dickschicht-Schaltungsanordnung oder wesentlicher Teile gegen unbefugten Zugriff folgender Schichtaufbau der gesinterten, nicht-leitfähigen Isolierschicht vorgenommen ist:
1. eine Füllschicht (7) in den Zwischenräumen füllt diese zwischen den elektrisch wirksamen Dickschicht-Leiterstrukturen (5) derart auf, daß die Oberseiten der elektrisch wirksamen Strukturen (5) und der die Zwischenräume zwischen ihnen füllenden, isolierenden, aus Isolierpaste gebildeten Füllschicht (7) angenähert in einer Ebene liegen,so daß eine kombinierte Leiter-/Füllschicht (11) gebildet ist,
2. es ist wenigstens eine isolierende erste Dickschicht-Zugriffsschutzschicht (13) deckend und einebnend über der kombinierten Leiter-/Füllschicht (11) angeordnet, die durch zusätzliche Sichtbehinderungseinlagen (Farbe, Partikel) ein optisches Erkennen der darunterliegenden Strukturen erschwert.

2. Dickschicht-Schaltungsanordnung nach Anspruch 1, dadurch gekennzeichnet, daß die erste Dickschicht-Zugriffsschutzschicht (13) mit wenigstens einer zweiten Dickschicht-Zugriffsschutzschicht (16) abgedeckt ist, die wenigstens teilweise flächig, leitend ausgebildet ist und/oder wenigstens teilweise weitere Leiterstrukturen aufweist, die elektrisch funktionsfähig oder funktionsunfähig sind.

3. Dickschicht-Schaltungssanordnung nach Anspruch 2, dadurch gekennzeichnet, daß der Schichtaufbau und die Abdeckung der zweiten Dickschicht-Zugriffsschicht (16), soweit weitere Leiterstrukturen vorhanden sind, wie bei der kombinierten Leiter-/Füllschicht (11) und der ersten Dickschicht-Zugriffsschutzschicht (13) erfolgt.

4. Dickschicht-Schaltungsanordnung nach einem oder mehreren der Ansprüche 1 bis 3, dadurch gekennzeichnet, daß sich der Schichtaufbau wenigstens einmal übereinander wiederholt.

5. Dickschicht-Schaltungsanordnung nach Anspruch 3, dadurch gekennzeichnet, daß die zweite Dickschicht-Zugriffsschutzschicht (16) in Form von weiteren Leiterstrukturen aufgebaut ist, die wenigstens teilweise an funktionsspezifischen Stellen in die elektronische Schaltung der Schaltungsanordnung eingreifen.

6. Dickschicht-Schaltungsanordnung nach Anspruch 5, dadurch gekennzeichnet, daß die zweite Dickschicht-Zugiffsschutzschicht (16) in die elektronische Schaltung der Schaltungsanordnung derart eingreift, daß bei Unterbrechungen oder Kurzschlüssen der Strukturen der zweiten Zugriffsschutzschicht (16) Funktionsfehler, wie Speicherverluste oder Speicherlöschungen, in Schaltkreisen der Schaltungsanordnung hervorgerufen werden.

7. Dickschicht-Schaltungsanordnung nach einem der Ansprüche 1 bis 6, dadurch gekennzeichnet, daß auf der Rückseite der keramischen Substratplatte (3) ein weiterer gegen unbefugten Zugriff sichernder Schaltungsaufbau mit Abdeckungen wie auf der Vorderseite vorgesehen ist.

8. Dickschicht-Schaltungsanordnung nach Anspruch 7, dadurch gekennzeichnet, daß auf der Rückseite wenigstens eine zweite Dickschicht-Zugriffsschutzschicht (16R) in Kombination mit wenigstens einer Füll- (7R) und einer ersten Zugriffsschutzschicht (13R) auf der Substratplatte (3) angeordnet ist.

9. Dickschicht-Schaltungsanordnung nach einem der Ansprüche 1 bis 8, dadurch gekennzeichnet, daß die die Zwischenräume der elektrisch wirksamen Dickschicht-Struktur auffüllende Dickschicht-Füllschicht (7,7R) eine gesinterte Dickschicht-Glasschicht ist.

10. Dickschicht-Schaltungsanordnung nach einem der Ansprüche 1 bis 9, dadurch gekennzeichnet, daß die abdeckende und einebnende erste Dickschicht-Zugriffsschutzschicht (13,13R) aus einer gesinterten Dickschicht-Glasschicht besteht.

11. Dickschicht-Schaltungsanordnung nach einem der Ansprüche 2 und 5 bis 7, dadurch gekennzeichnet, daß die zweite Dickschicht-Zugriffsschutzschicht (16) ganz oder in einer bzw. mehreren Teilflächen aus einer gesinterten Dickschicht-Leiter- und/oder Widerstandspaste gebildet ist.

12. Dickschicht-Schaltungsanordnung nach Anspruch 5, dadurch gekennzeichnet, daß die Leiterstrukturen (5) als Mäander (39a), als Kamm (39d), als Spirale (39b) oder als Schaltbilder (39e,f) ausgebildet sind.

13. Dickschicht-Schaltungsanordnung nach Anspruch 12, dadurch gekennzeichnet, daß die Leiter der Schaltbilder (39e,f) zur Täuschung für die Funktion notwendige und/oder überflüssige und/oder eine andere Funktion vortäuschende Verbindungen herstellen.

14. Dickschicht-Schaltungsanordnung nach einem der Ansprüche 2, 5 bis 7 oder 11 bis 13, dadurch gekennzeichnet, daß die Spannungs- bzw. Stromversorgung für die integrierten Schaltkreise über die zweite Dickschicht-Zugriffsschutzschicht (16,16R) erfolgt.

## Claims

1. A thick-film circuit arrangement comprising an electronic circuit which is constructed on a front side (17) of a ceramic substrate plate (3) and which consists of conductor patterns (5) and components, in particular integrated circuits without a housing, which are formed according to thick-film technology, and comprising a sintered, non-conductive insulating layer which substantially fills the spaces between said sintered conductor patterns (5) and which also covers the conductor patterns (5), characterized in that to protect the thick-film circuit arrangement or essential parts thereof against unauthorized access the sintered, non-conductive insulating layer is constructed as follows:
1. a filling layer (7) in the interspaces fills said spaces between the electrically operative thick-film conductor patterns (5) in such a manner that the top sides of the electrically active patterns (5) and of the insulating filling layer (7) formed from an insulating paste and filling the interspaces between them are situated substantially in one plane, so that a combined conductor/filling layer (11) is formed,
2. at least one insulating first thick-film anti-access layer (13) is provided on the combined conductor/filling layer (11) so as to form a level covering, and additional observation-impeding inclusions (dye, particles) are employed to impede optical recognition of the underlying structures.

2. A thick-film circuit arrangement as claimed in Claim 1, characterized in that the first thick-film anti-access layer (13) is covered by at least one second thick-film anti-access layer (16) which is constructed so as to have an at least partly and conductive surface and/or comprise at least partly further conductor patterns which are electrically operative and/or in-operative.

3. A thick-film circuit arrangement as claimed in Claim 2, characterized in that the second thick-film anti-access layer (16) is structured and covered in the same manner as the combined conductor/filling layer (11) and the first thick-film anti-access layer (13), in so far as further conductor patterns are present.

4. A thick-film circuit arrangement as claimed in any one of the Claims 1 to 3, characterized in that the layer structure is repeated at least once in such a manner that the at least two layer structures are situated on top of each other.

5. A thick-film circuit arrangement as claimed in Claim 3, characterized in that the second thick-film anti-access layer (16) is constructed in the form of further conductor patterns which engage in the electronic circuit of the circuit arrangement, at least partly, in functionally specific places.

6. A thick-film circuit arrangement as claimed in Claim 5, characterized in that the second thick-film anti-access layer (16) engages in the electronic circuit of the circuit arrangement in such a manner that in the case of interruptions or short-circuits of the patterns of the second anti-access layer (16) operational errors, such as storage loss or storage erasing, are produced in integrated circuits of the circuit arrangement.

7. A thick-film circuit arrangement as claimed in any one of the Claims 1 to 6, characterized in that a further anti-access circuit structure with coverings is provided on the rear side of the ceramic substrate plate (3) in the same manner as on the front side.

8. A thick-film circuit arrangement as claimed in Claim 7, characterized in that at least one second thick-film anti-access layer (16R), in combination with at least one filling (layer 7R) and a first anti-access layer (13R) is provided on the rear side of the substrate plate (3).

9. A thick-film circuit arrangement as claimed in any one of the Claims 1 to 8, characterized in that the thick-film filling layer (7,7R) filling the interspaces of the electrically operative thick-film structure is a sintered thick-film glass layer.

10. A thick-film circuit arrangement as claimed in any one of the Claims 1 to 9, characterized in that the covering and levelling first thick-film anti-access layer (13,13R) is a sintered thick-film glass layer.

11. A thick-film circuit arrangement as claimed in any one of the Claims 2 and 5 to 7, characterized in that the entire second thick-film anti-access layer (16) or one or several of its sub-layers is (are) formed from a sintered thick-film conductor and/or resistor paste.

12. A thick-film circuit arrangement as claimed in Claim 5, characterized in that the conductor patterns (5) are formed as a meander (39a), a comb (39d), a coil (39b) or a circuit diagram (39e,f).

13. A thick-film circuit arrangement as claimed in Claim 12, characterized in that, for delusion purposes, the conductors of the circuit diagrams (39e,f), produce connections which are necessary and/or superfluous for the function and/or simulate a different function.

14. A thick-film circuit arrangement as claimed in any one of the Claims 2, 5 to 7 or 11 to 13, characterized in that the voltage or current supply for the integrated circuits occurs via the second thick-film anti-access layer (16,16R).

## Revendications

1. Dispositif de circuit à couche épaisse muni d'un circuit électronique formé sur une face avant (17) d'une plaque de substrat céramique (3) et constitué par des structures de conducteurs (5) et des composants formés dans la technique des couches épaisses, notamment des circuits de commutation intégrés sans boîtier, d'une couche isolante non conductrice frittée qui remplit essentiellement les espaces intermédiaires entre les structures de conducteurs frittées (5) et qui recouvre également les structures de conducteurs, caractérisé en ce que pour le recouvrement du dispositif de circuit à couche épaisse ou les parties essentielles contre l'accès non autorisé, la structure de couche de la couche isolante non conductrice frittée est réalisée comme suit:
1. une couche de remplissage (7) dans les espaces intermédiaires les remplit entre les structures de conducteurs à couche épaisse électriquement actives (5) de façon que les faces supérieures des structures électriquement actives (5) et de la couche de remplissage isolante (7) formée en pâte isolante et remplissant les espaces intermédiaires entre ces dernières se situent pratiquement dans un plan de façon qu'il se forme une couche de remplissage et de conducteurs 11,
2. au moins une première couche protectrice d'accès à couche épaisse isolante (13) est disposée de façon couvrante et égalisatrice au-dessus de la couche de remplissage et de conducteurs combinée 11, qui complique une reconnaissance optique des structures sous-jacentes par des revêtements additionnels constituant un obstacle à la visibilité (couleurs, particules).

2. Dispositif de circuit à couche épaisse selon la revendication 1, caractérisé en ce que la première couche protectrice d'accès à couche épaisse (13) est recouverte d'au moins une deuxième couche protectrice d'accès à couche épaisse (16), qui est au moins partiellement réalisée de façon plane, conductrice et/ou qui présente au moins partiellement d'autres structures de conducteurs, qui peuvent fonctionner électriquement ou non.

3. Dispositif de circuit à couche épaisse selon la revendication 2, caractérisé en ce que la structure de couche et le recouvrement de la deuxième couche protectrice d'accès à couche épaisse (16) pour autant que d'autres structures de conducteurs sont présentes, s'effectuent comme dans le cas de la couche de remplissage et de conducteurs combinée (11) et la première couche protectrice d'accès à couche épaisse (13).

4. Dispositif de circuit à couche épaisse selon l'une ou plusieurs des revendications 1 à 3, caractérisé en ce que la structure de couche se répète au moins une fois de façon superposée.

5. Dispositif de circuit à couche épaisse selon la revendication 3, caractérisé en ce que la deuxième couche protectrice d'accès à couche épaisse (16) est réalisée sous forme d'autres structures de conducteurs qui interviennent au moins partiellement aux endroits spécifiques pour le fonctionnement dans le circuit électronique du dispositif de circuit.

6. Dispositif de circuit à couche épaisse selon la revendication 5, caractérisé en ce que la deuxième couche protectrice d'accès à couche épaisse (16) intervient dans le circuit électronique du dispositif de circuit de façon que dans le cas d'interruptions ou de court-circuits des structures de la deuxième couche protectrice d'accès (16) des défauts de fonctionnement, tels que des pertes de mémoire ou des effacements de mémoire, soient provoqués dans les circuits de commutation du dispositif de circuit.

7. Dispositif de circuit à couche épaisse selon l'une des revendications 1 à 6, caractérisé en ce que sur la face arrière de la plaque de substrat céramique 3 est prévue une autre structure de circuit protégeant contre l'accès non autorisé et présentant des recouvrements comme celui de la face avant.

8. Dispositif de circuit à couche épaisse selon la revendication 7, caractérisé en ce que sur la face arrière est disposée au moins une deuxième couche protectrice d'accès à couche épaisse (16R) en combinaison avec au moins une couche de remplissage (7R) et une première couche protectrice d'accès (13R) sur la plaque de substrat 3.

9. Dispositif de circuit à couche épaisse selon l'une des revendications 1 à 8, caractérisé en ce que la couche de remplissage à couche épaisse (7, 7R) remplissant les espaces intermédiaires de la structure à couche épaisse électriquement active est une couche en verre à couche épaisse frittée.

10. Dispositif de circuit à couche épaisse selon l'une des revendieations 1 à 9, caractérisé en ce que la première couche protectrice d'accès à couche épaisse recouvrante et égalisatrice (13, 13R) est constituée par une couche en verre à couche épaisse frittée.

11. Dispositif de circuit à couche épaisse selon l'une des revendications 2 et 5 à 7, caractérisé en ce que la deuxième couche protectrice d'accès à couche épaisse (16) est formée entièrement ou dans une ou plusieurs surfaces partielle(s) en une pâte de résistance et/ou conductrice de couche épaisse.

12. Dispositif de circuit à couche épaisse selon la revendication 5, caractérisé en ce que les structures de conducteurs (5) sont sous forme de méandre (39a) de peigne (39d), de spirale (39b) ou de schéma de conducteurs (39e, f).

13. Dispositif de circuit à couche épaisse selon la revendication 12, caractérisé en ce que pour la tromperie, les conducteurs des schémas de conducteurs (39e, f) établissent des connexions nécessaires pour le fonctionnement et/ou superflues et/ou simulant une autre fonction.

14. Dispositif de circuit à couche épaisse selon l'une des revendications 2, 5 à 7 ou 11 à 13, caractérisé en ce que l'alimentation en tension respectivement courant pour le circuit de commutation intégré s'effectue par l'intermédiaire de la deuxième couche protectrice d'accès à couche épaisse (16, 16R).
